(19) **Europäisches Patentamt**
**European Patent Office**
**Office européen des brevets**

(11) **EP 3 498 893 B1**

(12) **FASCICULE DE BREVET EUROPEEN**

(45) Date de publication et mention
de la délivrance du brevet:
**27.05.2020 Bulletin 2020/22**

(51) Int Cl.:
***C30B 29/06*** *(2006.01)*   ***C30B 33/04*** *(2006.01)*

(21) Numéro de dépôt: **18210122.0**

(22) Date de dépôt: **04.12.2018**

(54) **PROCEDE D'EXTRACTION D'IMPURETES METALLIQUES D'UNE PLAQUETTE DE SILICIUM CRISTALLIN**

EXTRAKTIONSVERFAHREN VON METALLISCHEN UNREINHEITEN AUS EINEM PLÄTTCHEN AUS KRISTALLINEM SILIZIUM

METHOD FOR EXTRACTING METAL IMPURITIES FROM A CRYSTALLINE SILICON WAFER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2017 FR 1762008**

(43) Date de publication de la demande:
**19.06.2019 Bulletin 2019/25**

(73) Titulaire: **Commissariat à l'Energie Atomique et aux Energies Alternatives**
**75015 Paris (FR)**

(72) Inventeurs:
• **DUBOIS, Sébastien**
**38054 GRENOBLE Cedex 09 (FR)**
• **ENJALBERT, Nicolas**
**38054 GRENOBLE Cedex 09 (FR)**
• **GARANDET, Jean-Paul**
**38054 GRENOBLE Cedex 09 (FR)**

(74) Mandataire: **Nony**
**11 rue Saint-Georges**
**75009 Paris (FR)**

(56) Documents cités:
**WO-A1-2013/045767     DE-A1-102011 056 843**
**FR-A1- 2 949 607**

• **W. P. LEE ET AL: "Enhanced gettering of iron impurities in bulk silicon by using external direct current electric field", JOURNAL OF ELECTRONIC MATERIALS., vol. 34, no. 7, 1 juillet 2005 (2005-07-01), pages 25-29, XP055476741, US ISSN: 0361-5235, DOI: 10.1007/s11664-005-0101-x**

**Description**

La présente invention a pour objet un procédé d'extraction d'impuretés métalliques d'une plaquette de silicium cristallin. Elle a également trait à une cellule photovoltaïque ayant été traitée à l'aide dudit procédé.

Les plaquettes de silicium cristallin contiennent des impuretés métalliques telles que des atomes de cuivre, de nickel, de cobalt, de fer et/ou de chrome. Les concentrations de ces éléments sont généralement comprises entre $10^8$ cm$^{-3}$ et $10^{15}$ cm$^{-3}$.

Les plaquettes de silicium cristallin sont en particulier utilisées dans la fabrication de cellules photovoltaïques. Le rendement de conversion de ces dernières est limité par la présence des impuretés métalliques qu'elles contiennent. Ces dernières altèrent la durée de vie des porteurs de charges. Les impuretés métalliques peuvent également entraîner des effets de dégradation sous éclairement des performances des cellules qui les contiennent.

Pour s'affranchir de ces limitations, différents procédés pour extraire les impuretés métalliques d'une plaquette de silicium cristallin sont connus.

La plupart des procédés de fabrication des cellules photovoltaïques développent des effets getter externes et de passivation par l'hydrogène des impuretés métalliques initialement présentes dans le substrat. Les effets getter externes consistent à extraire des impuretés métalliques de la base de la cellule et à les confiner dans des régions moins critiques vis-à-vis des performances du dispositif. La technique privilégiée de mise en œuvre des effets getter externes est l'étape de dopage superficiel de la plaquette, permettant de former la jonction pn de la cellule, notamment via la diffusion thermique du phosphore lorsque le substrat est de type p. Les effets de passivation par l'hydrogène sont généralement liés à l'utilisation de couches de nitrure de silicium hydrogéné, déposées sur les surfaces, desquelles migrent les atomes d'hydrogène pour électriquement passiver les impuretés restantes.

Ces traitements sont effectivement efficaces pour neutraliser une partie importante des impuretés métalliques initialement présentes dans le substrat. Cependant, à l'issue de ces traitements, les teneurs résiduelles en impuretés métalliques peuvent être encore suffisamment élevées pour limiter le rendement et provoquer des effets de dégradation sous éclairement des performances des cellules qui les contiennent.

Les demandes JP2007095774 et WO 2013/045767 présentent des procédés d'extraction des impuretés métalliques basés sur la génération de charges électriques à la surface d'une plaquette de silicium, afin d'établir un champ électrique dans le substrat, permettant aux atomes métalliques, comme le cuivre, de migrer sur l'une des surfaces. Dans ces demandes, le cuivre piégé à la surface de la plaquette est potentiellement instable. Il peut donc lors d'étapes successives ou au cours du fonctionnement du dispositif, migrer à nouveau dans la plaquette de silicium.

La demande JP2007095774 réduit ce risque en proposant de graver, par voie chimique, la surface de la plaquette sur laquelle se sont accumulés les éléments métalliques. Cependant, cela entraîne des étapes technologiques supplémentaires qui ne sont pas forcément compatibles avec le procédé de fabrication de la cellule photovoltaïque.

La demande internationale WO 2013/045767 propose d'établir le champ électrique en déposant ou formant des couches diélectriques à la surface des plaquettes, et de déposer une charge Corona. Cependant, le dépôt de charges Corona est difficile à contrôler et est mal adapté aux surfaces de plaquettes de silicium. De plus, la présence de charges Corona est parfois préjudiciable à l'utilisation ultérieure de la plaquette.

WO 2013/045767 propose également de déposer directement une couche diélectrique contenant des charges fixes. Cependant cela restreint le choix des couches diélectriques pouvant être déposées, ce qui offre peu de flexibilité en matière d'architecture des cellules.

L'article W.P. Lee et al, Journal of ELECTRONIC MATERIALS, Vol. 34, No. 7, 2005 ainsi que les brevets US 5,770,000 et US 6,534,748 proposent d'appliquer une différence de potentiel électrique entre deux électrodes disposées de chaque côté d'un échantillon semi-conducteur. Sous l'effet du champ électrique alors présent, les impuretés métalliques sont extraites du matériau semi-conducteur. Dans ces documents, les électrodes sont placées en vis-à-vis des deux côtés de l'échantillon et une des électrodes est espacée de l'échantillon par une couche de vide ou de gaz. Ainsi, la mise en œuvre des traitements décrits dans ces documents nécessite l'utilisation d'une enceinte spécifique, dans laquelle il est possible de faire le vide ou d'injecter des gaz. De plus, le contrôle de la valeur du champ électrique créé dans le volume du dispositif est complexe.

Il est également connu des demandes WO 2007/107351, DE 10 2009 059 300 et FR 2 949 607 un traitement de cellules photovoltaïques comportant une jonction pn permettant de neutraliser de façon permanente un complexe associant le bore et l'oxygène. Ce traitement utilise les actions combinées de la température supérieure ou égale à 50°C et de l'injection de charges minoritaires dans la cellule. Les charges minoritaires sont injectées par l'application d'une différence de potentiel électrique entre deux électrodes disposées de part et d'autre de la cellule et donc de la jonction pn.

Il est également connu de la demande FR 2 949 607 un traitement d'une cellule photovoltaïque comportant une jonction pn utilisant les actions combinées de la température comprise entre 300°C et 500°C et de la polarisation électrique en direct d'une structure de collecte des charges minoritaires. La polarisation électrique permet d'injecter des charges libres dans le volume de la cellule. Ce traitement permet de limiter les effets de dégradation sous éclairement du rendement liés à la formation des complexes associant le bore et l'oxygène.

Au regard des limitations des procédés déjà disponibles, il demeure un besoin de disposer d'un procédé d'extraction des impuretés métalliques d'une plaquette de silicium cristallin qui soit à la fois efficace et facile à mettre en œuvre.

L'invention vise précisément à répondre à ce besoin, selon un premier de ses aspects, et elle y parvient à l'aide d'un procédé d'extraction d'impuretés métalliques d'une plaquette de silicium cristallin comportant une étape d'application, pendant une durée supérieure ou égale à 1s, de préférence entre 1s et 200s, une différence de potentiel électrique entre une première électrode disposée du côté d'une première face de la plaquette et une deuxième électrode disposée du côté de la deuxième face de la plaquette opposée à la première pour faire migrer les impuretés métalliques vers une des première ou deuxième faces de la plaquette, la différence de potentiel électrique étant, en valeur absolue, comprise entre 1V et 10kV, mieux comprise entre 3V et 5kV, la première électrode comportant au moins deux pistes et la deuxième électrode comportant au moins une piste dont la projection sur la première face de la plaquette selon une normale à cette dernière est intercalée entre les deux pistes adjacentes de la première électrode.

L'application de la différence de potentiel électrique entre les deux électrodes permet d'induire, sur les impuretés métalliques chargées, une force F vers l'une des faces de la plaquette. Une telle force F favorise la migration des impuretés métalliques vers ladite face de la plaquette, ce qui permet de piéger ces dernières dans la plaquette en surface de ladite face sous l'électrode, ou dans l'électrode. La migration des impuretés se fait à condition que la force appliquée l'emporte sur la diffusion brownienne, c'est-à-dire à condition que la force soit telle que :

$$FL_{Drift}/kT >> 1$$

$L_{Drift}$ correspondant à la distance entre l'impureté et la surface vers laquelle elle migre, k la constante de Boltzmann et T la température en Kelvin.

La disposition particulière des pistes de première et deuxième électrode permet de favoriser l'uniformité du champ électrique dans la plaquette, par rapport à une disposition en vis-à-vis des électrodes.

De préférence, la projection sur la première face de la plaquette selon une normale à cette dernière de la piste de deuxième électrode est disjointe des pistes de première électrode, c'est-à-dire qu'elle ne se superpose pas aux pistes de première électrode. Ceci permet d'améliorer l'efficacité du traitement d'extraction.

De préférence, les impuretés métalliques extraites sont parmi les métaux diffuseurs dits rapides, notamment le cuivre, le fer, le cobalt, le nickel, le manganèse et le chrome.

De préférence, le procédé comporte une étape préalable de dopage des surfaces de la plaquette, notamment par diffusion thermique de phosphore, de bore, d'arsenic ou de gallium, préférentiellement de phosphore ou de bore.

Le dopage des surfaces de la plaquette permet de créer la jonction pn et d'extraire une partie des impuretés métalliques par effet getter externe.

De préférence, le procédé comporte une étape de dépôt ou de formation des première et deuxième électrode.

De préférence, le procédé comporte une étape de recuit de la plaquette, dit recuit rapide, en particulier à une température comprise entre 600°C et 1300°C, de préférence d'environ 800°C, pendant une durée comprise entre 1s et 10 min, de préférence d'une dizaine de secondes environ, avant un refroidissement à une vitesse de refroidissement supérieure ou égale en valeur absolue à 10 K.s$^{-1}$, de préférence comprise entre 40 K.s$^{-1}$ et 60 K.s$^{-1}$, de préférence entre 45 K.s$^{-1}$ et 55 K.s$^{-1}$, mieux sensiblement égale à 50 K.s$^{-1}$. De préférence, cette étape à lieu entre l'étape de dépôt ou de formation des première et deuxième électrodes et l'étape d'application de la différence de potentiel électrique. En variante, l'étape de recuit a lieu simultanément à l'étape d'application de la différence de potentiel électrique.

Le recuit de la plaquette permet de favoriser la dissolution des précipités métalliques et de laisser les impuretés métalliques de la plaquette en solution solide.

De préférence, le procédé est mis en œuvre à une température comprise entre 10°C et 850°C, mieux entre 15°C et 300°C, encore mieux entre 80°C et 270°C. Le fait de chauffer la plaquette permet de faciliter l'extraction des impuretés métalliques.

De préférence, le procédé est mis en œuvre à atmosphère ambiante.

La première et la deuxième électrode peuvent être déposées ou formées en contact direct avec la plaquette ou une couche ou une pluralité de couches en contact direct avec la plaquette.

De préférence, la plaquette de silicium présente moins de 10$^{15}$ at.cm$^3$ de bore et moins de 4$\times$10$^{17}$ at. cm$^{-3}$ d'oxygène.

La différence de potentiel électrique entre la première électrode et la deuxième électrode peut être positive ou négative selon la face vers laquelle on souhaite faire migrer les impuretés métalliques et le signe de la charge des impuretés en présence. Une différence de potentiel électrique entre la première et la deuxième électrode positive permet de faire migrer les impuretés métalliques de charge généralement positive vers la deuxième face et inversement, une différence de potentiel électrique négative permet de faire migrer les impuretés métalliques de charge généralement positive vers la première face.

De préférence, la projection sur la première face de la plaquette selon une normale à cette dernière de la première électrode est disjointe de la deuxième électrode. Ceci permet d'améliorer l'efficacité du traitement d'extraction en permettant que le champ électrique balaye un grand volume.

De préférence, la piste de deuxième électrode est à égale distance des pistes de première électrode. Ceci permet d'homogénéiser le champ électrique appliqué dans la plaquette.

De préférence, la première électrode se présente sous la forme d'un peigne, chaque dent du peigne constituant une piste de la première électrode, la deuxième électrode présentant une pluralité de pistes dont les projections sur la première face de la plaquette selon une normale à cette dernière sont intercalées entre deux pistes adjacentes de la première électrode. Une telle configuration des électrodes permet de traiter une grande surface de la plaquette efficacement et uniformément.

De préférence, les pistes de première électrode sont reliées entre elles par au moins une piste de liaison (autrement appelée « bus bar ») de préférence perpendiculaire aux pistes de première électrode, en projection sur la première face de la plaquette selon une normale à cette dernière, la piste de liaison étant notamment disjointe de la ou des pistes de deuxième électrode.

De préférence, les pistes de première électrode sont reliées entre elles par une pluralité de pistes de liaisons telles que décrites ci-dessus de sorte que la première électrode forme une grille. Ceci permet en particulier d'homogénéiser le champ électrique dans la plaquette de sorte à améliorer l'extraction des impuretés métalliques.

De préférence, les pistes de première électrode sont parallèles entre elles et séparées d'une distance comprise entre 0,3 mm et 3 mm, mieux entre 1 mm et 2 mm.

De préférence, les pistes de deuxième électrode sont parallèles entre elles et séparées d'une distance comprise entre 0,3 mm et 3 mm, mieux entre 1 mm et 2 mm

De préférence, les pistes de première électrode sont sensiblement parallèles à la ou aux pistes de deuxième électrode, la ou les pistes de deuxième électrode s'étendant de préférence à égale distance des pistes de première électrode adjacentes.

La largeur des pistes de première et deuxième électrodes peut être comprise entre 500 nm et 100 $\mu$m, mieux entre 5 $\mu$m et 60 $\mu$m.

De préférence, les pistes de première et deuxième électrodes sont rectilignes.

De préférence, le procédé comporte une étape de recouvrement partielle de la deuxième face de la plaquette par une couche diélectrique, puis une étape de dépôt de la deuxième électrode sur toute la deuxième face pour qu'elle s'étende sur une ou plusieurs zones de la deuxième face de la plaquette dépourvues de couche diélectrique pour définir la ou les pistes de deuxième électrode. Une telle couche diélectrique permet d'isoler électriquement la plaquette de la deuxième électrode dans les zones où elle est présente.

De préférence, les première et deuxième électrodes sont imprimées par sérigraphie.

Le procédé peut comporter une étape de dépôt des pistes de la première électrode directement en contact avec la première face de la plaquette.

En variante, le procédé comporte une étape de recouvrement au moins partielle de la première face de la plaquette d'une couche isolante, étant de préférence un empilement de plusieurs couches diélectriques, d'épaisseur comprise entre 2 nm et 500 nm, mieux entre 10 nm et 300 nm et une étape de dépôt des pistes de première électrode sur la couche isolante.

Le procédé peut comporter une étape de dépôt de la ou des pistes de la deuxième électrode en contact de la deuxième face de la plaquette.

En variante, le procédé comporte une étape de recouvrement au moins partielle de la deuxième face de la plaquette d'une couche isolante, étant de préférence un empilement de plusieurs couches diélectriques, d'épaisseur comprise entre 2 nm et 500 nm, mieux entre 10 nm et 300 nm et une étape de dépôt de la ou des pistes de la deuxième électrode sur la couche isolante.

Dans le cas où une couche isolante est présente entre les pistes de première électrode et la plaquette et/ou entre la ou les pistes de deuxième électrode et la plaquette, la ou les couches isolantes sont constituées d'un ou d'empilement de matériaux diélectriques, notamment choisi parmi $SiO_x$, $SiN_x$, $AlO_x$, $HfD_2$, SiON.

La présence d'au moins une couche isolante entre l'une des deux électrodes et la surface de la plaquette permet d'éviter le passage d'un courant électrique permanent dans la plaquette lors de l'application de la différence de potentiel électrique et d'éviter ainsi que la plaquette chauffe, ce qui pourrait entraîner des dégradations irréversibles du dispositif.

Dans le cas où au moins une couche isolante est présente entre une des électrodes et la plaquette, de préférence où au moins une couche isolante est présente entre chacune des électrodes et la plaquette, la différence de potentiel électrique appliquée entre les première et deuxième électrodes est comprise, en valeur absolue, entre 10 V et 10 kV.

En variante, les deux électrodes sont en contact avec les faces de la plaquette. Dans ce cas, la différence de potentiel électrique appliquée entre les première et deuxième électrodes est, de préférence, comprise, en valeur absolue, entre 1 V et 100 V.

La plaquette de silicium peut comporter une jonction pn entre la première et la deuxième électrode.

Par «jonction pn », on comprend toute structure permettant la collecte des charges minoritaires photogénérées telles que les jonctions pn, les structures à contacts passivés, les homojonctions ou les hétérojonctions.

En variante, la plaquette de silicium ne comporte pas de jonction pn.

La plaquette de silicium peut avoir une base et au moins une couche émetteur du côté de la première face ; par exemple une couche fortement dopée ; et le procédé peut comporter une étape de gravure localisée de la première face traversant la couche émetteur Dans ce cas, les pistes de première électrode sont disposées sur la première face dans les zones de la plaquette gravée. Dans ce cas, il est préférentiel que la première électrode soit isolée électriquement de la couche émetteur, notamment espacée de la couche émetteur.

La plaquette de silicium peut avoir une base et au moins une couche émetteur du côté de la deuxième face ; par exemple une couche fortement dopée ; et le procédé peut comporter une étape de gravure localisée de la deuxième face traversant la couche émetteur Dans ce cas, les pistes de deuxième électrode sont disposées sur la deuxième face dans les zones de la plaquette gravée. Il est préférentiel que la deuxième électrode soit isolée électriquement de la couche émetteur, notamment espacée de la couche émetteur.

Le procédé peut comporter une étape de dépôt d'une troisième électrode du côté de la face de la plaquette avec la couche émetteur, dans les zones de la plaquette non gravée, la troisième électrode étant espacée de l'électrode disposée sur la même face.

En variante, le procédé comporte les étapes de dépôt d'une couche d'un matériau isolant sur la première électrode et de dépôt d'une troisième électrode du côté de la première face de la plaquette dans la zone non gravée et au moins partiellement sur la couche de matériau isolant.

Le principal intérêt de cette mise en œuvre particulière est de minimiser le risque de dégradation irréversible de la jonction pn.

Ainsi, dans les deux variantes ci-dessus, la troisième électrode et la première électrode sont isolées électriquement l'une de l'autre. La première électrode peut alors rester en place sur la plaquette de silicium pendant l'utilisation ultérieure de cette dernière, notamment en tant que cellule photovoltaïque, sans que la première électrode ne viennent court-circuiter la couche émetteur.

En variante, le procédé peut comporter une étape de retrait de la première électrode après l'étape d'application de la différence de potentiel électrique.

L'invention a également trait, selon un autre de ses aspects, à une cellule photovoltaïque comportant :

- une plaquette de silicium cristallin comportant une couche de base et une couche émetteur, la plaquette présentant sur une première face au moins une zone gravée traversant la couche émetteur,
- une première électrode comportant au moins une piste s'étendant dans la zone gravée,
- une deuxième électrode comportant au moins une piste s'étendant sur un deuxième côté de la plaquette de silicium cristallin, la piste de la deuxième électrode étant, en projection par rapport à la première face selon une normale à cette dernière, disjointe de la piste de première électrode,
- une troisième électrode comportant au moins une piste s'étendant au moins partiellement sur la couche émetteur, sur le premier côté de la plaquette de silicium cristallin, la troisième électrode étant isolée électriquement de la première électrode. De préférence, la première électrode comporte au moins deux pistes s'étendant dans une ou deux zones gravées, la piste de deuxième électrode étant intercalée entre les pistes de première électrode.

La troisième électrode peut être espacée de la première électrode ou isolée électriquement de cette dernière par une couche d'un matériau isolant.

La cellule photovoltaïque peut comporter une différence de potentiel électrique entre la premier et la deuxième électrode comprise entre 1V et 10kV, et de préférence comprise entre 3V et 5kV pendant une durée supérieure ou égale à 1 seconde, et de préférence pendant une durée entre 1 seconde et 200 secondes.

Les caractéristiques décrites précédemment en relation avec le procédé s'appliquent également à la cellule photovoltaïque ci-dessus.

## Description détaillée

L'invention pourra être mieux comprise à la lecture de la description détaillée qui va suivre, d'exemples non limitatifs de mise en œuvre de celle-ci, et à l'examen du dessin annexé, sur lequel :

- la figure 1 est une représentation schématique et partielle, en coupe, d'un exemple de disposition des électrodes sur la plaquette de silicium cristallin avec un contact direct entre l'électrode et la plaquette de silicium cristallin,
- la figure 2 illustre une variante de la figure 1 avec la présence de couches isolantes entre les électrodes et la plaquette de silicium cristallin,
- la figure 3 représente partiellement, en vue du dessus, une variante de disposition des électrodes sur la plaquette de silicium cristallin,
- la figure 4 est une vue en coupe partielle selon IV-IV de la variante de la figure 3,
- la figure 5 est un graphique représentant le temps de traitement pour l'extraction du cuivre d'une plaquette de silicium cristallin par rapport à la différence de potentiel électrique appliquée, et ce pour différentes températures de traitement, les électrodes étant disposé sur la plaquette de silicium selon la variante des figures 3 et 4,
- la figure 6 illustre une variante de la figure 1,
- les figures 7 et 8 sont des représentations schématiques et partielles, en coupe, de variantes de disposition d'une troisième électrode dans le cas de la figure 6,
- la figure 9 illustre une variante de la figure 1,
- la figure 10 est une vue du dessus de la figure 9,
- la figure 11 est un graphique représentant le temps de traitement pour l'extraction du cuivre d'une plaquette de silicium cristallin par rapport à la différence de potentiel électrique appliquée, et ce pour différentes concentration de bore dans la plaquette de silicium cristallin, les électrodes étant disposées sur la plaquette de silicium selon la variante des figures 3 et 4, et

- la figure 12 est un graphique représentant le temps de traitement pour l'extraction du fer d'une plaquette de silicium cristallin par rapport à la différence de potentiel électrique appliquée, et ce pour différentes températures de traitement, les électrodes étant disposées sur la plaquette de silicium selon la variante des figures 3 et 4.

Différentes étapes d'un exemple de procédé d'extraction d'impuretés métalliques d'une plaquette de silicium cristallin, selon l'invention, sont décrites en détails dans ce qui suit.

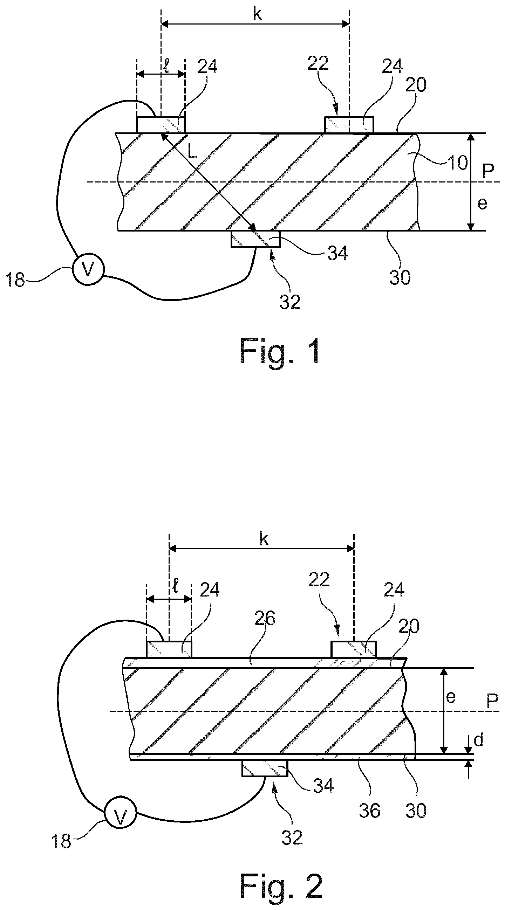

On a représenté en figure 1 un exemple de disposition des électrodes sur une plaquette de silicium cristallin 10 permettant de mettre en œuvre un procédé d'extraction des impuretés métalliques selon l'invention.

La plaquette de silicium 10 s'étend dans un plan d'extension P et présente une épaisseur $e$ comprise entre 5 $\mu$m et 2 mm, préférentiellement entre 40 $\mu$m et 200 $\mu$m.

Elle présente une première face 20 sur laquelle sont disposées, en contact direct avec le silicium, au moins deux pistes 24 d'une première électrode 22 et une deuxième face 30 sur laquelle est disposée, en contact direct, au moins une piste 34 d'une deuxième électrode 32. La piste 34 est disposée sur la deuxième face 30 de sorte que, lorsqu'elle est projetée sur la première face 20 de la plaquette 10 selon une normale à cette dernière, elle s'intercale entre les deux pistes 24. De préférence, la piste 34 est à égale distance de chacune des deux pistes 24, $k$ étant la distance entre les deux pistes 24.

De préférence, les première et deuxième électrodes 22 et 32 sont déposées par sérigraphie.

La largeur $l$ des pistes 24 et 34 est de préférence comprise entre 500 nm et 100 $\mu$m.

La distance $k$ entre les deux pistes 24 est de préférence comprise entre 0,8 mm et 3 mm, préférentiellement comprise entre 1 mm et 2 mm.

La plupart des impuretés métalliques présentes dans la plaquette 10 en position interstitielle ou substitutionnelle sont chargées électriquement, généralement positivement.

L'invention consiste à appliquer une différence de potentiel électrique V entre les deux électrodes 22 et 32. La différence de potentiel électrique V est appliquée à l'aide d'un générateur de tension 18 ou toute autre moyen. La différence de potentiel électrique V appliquée entre les deux électrodes 22 et 32 est comprise, en valeur absolue, entre 1 V et 100 V, par exemple sensiblement égale à 8V, pendant une durée comprise entre 1 s et 80 s, par exemple sensiblement égale à 5s.

Le champ électrique créé par cette différence de potentiel électrique V, induit une force $F$ sur les impuretés chargées, qui va favoriser leur migration vers l'une des faces 20 et 30. Les impuretés métalliques vont alors être piégées au niveau de ladite face 20 ou 30 sous l'électrode métallique 22 ou 32, voire dans l'électrode métallique 22 ou 32.

La force $F$ locale est définie par :

$$F = CV/L \quad (1)$$

$L$ étant la distance entre deux pistes 24 et 34 adjacentes, $L$ étant mesurée entre les centres des surfaces des pistes 24 et 34 du côté de la plaquette 10, $C$ étant la charge portée par l'impureté considérée.

Sous cette force $F$, l'impureté métallique chargée va migrer à la vitesse $V_{Drift}$ définie par :

$$V_{Drift} = DF/kT \quad (2)$$

$D$ étant le coefficient de diffusion de l'impureté considérée, $k$ la constante de Boltzmann et $T$ la température en Kelvin.

$V_{Drift}$ étant connue, le temps nécessaire $t_{Drift}$ à l'impureté métallique pour migrer sous cette différence de potentiel électrique sur la distance $L_{drift}$ vers la face 22 ou 32 peut alors être calculé :

$$t_{Drift} = L_{drift}/V_{Drift} \quad (3)$$

A noter que, dans l'invention, la diffusion sous champ électrique doit dominer la diffusion brownienne à l'échelle de longueur $L_{Drift}$. Pour cela, $V_{Drift}$ doit être plus grand que $V_B$, $V_B$ étant définie par :

$$V_B = D/L_{Drift} \quad (4)$$

Cela suppose la condition suivante :

$$FL_{Drift}/kT >> 1 \quad (5)$$

Cette condition est vérifiée par l'invention et dans les exemples décrits ci-dessous.

L'invention concerne toutes les impuretés métalliques électriquement chargées, en particulier les diffuseurs dits rapides dans le silicium, par exemple le cuivre, le fer, le cobalt, le nickel, le manganèse et le chrome. L'invention peut être mise en œuvre quelle que soit la concentration d'impuretés dans la plaquette. Toutefois, elle est particulièrement efficace quand la concentration de l'impureté métallique considérée est supérieure à sa limite de solubilité. L'invention n'est cependant pas limitée à une telle condition.

Pour faciliter la mise en œuvre de l'invention, en particulier pour favoriser son utilisation à l'échelle industrielle, il est possible de chauffer l'échantillon pendant le traitement. Ceci permet d'augmenter la valeur de $D$ et donc la vitesse de migration des impuretés. La température peut être comprise entre 10°C et 850°C, de façon préférentielle entre 15°C et 250°C.

L'invention peut être mise en œuvre après une étape de recuit dit rapide. Le recuit peut se faire selon un profil de température en fonction du temps tel que décrit dans l'article S. Dubois et al, SolMat, 2016. Un mode préférentiel de mise en œuvre de l'invention est d'appliquer la différence de potentiel électrique juste après le recuit de la plaquette, dans le four infra-rouge de recuit des contacts. Un tel recuit permet de favoriser la dissolution des précipités métalliques et d'immobiliser les impuretés métalliques en solution solide dans la plaquette. En variante, l'étape de recuit se fait simultanément à l'étape d'application de la différence de potentiel électrique.

Le mode de réalisation de la figure 2 diffère de celui de la figure 1 en ce que la première électrode 22 est déposée sur une première couche isolante 26 recouvrant au moins partiellement la première face 20 de la plaquette 10 et la deuxième électrode 32 est déposée sur une deuxième couche isolante 36 recouvrant au moins partiellement la deuxième face 30 de la plaquette 10. Ces couches isolantes 26 et 36 permettent d'éviter le passage d'un courant électrique permanent dans la plaquette 10 lors de l'application de la différence de potentiel électrique V, et par conséquent de limiter l'échauffement de la cellule, ce qui pourrait causer une dégradation irréversible de cette dernière.

Les couches isolantes peuvent présenter une épaisseur $d$ comprise entre 2 nm et 500 nm, de préférence entre 10 nm et 300 nm. Ces couches peuvent comporter un ou un empilement de plusieurs matériaux diélectriques tels que $SiO_x$, $SiN_x$, $AlO_x$, $HfO_2$, SiON. Elles peuvent être des couches anti-reflet et/ou de passivation électrique déposées pour la fabrication des cellules photovoltaïques. Dans ce cas, la différence de potentiel électrique V entre les deux électrodes 22 et 32 est préférentiellement comprise, en valeur absolue, entre 100 V et 1 kVV pendant une durée comprise entre 1 s et 80 s.

En variante non illustrée, seulement l'une des deux faces 20 ou 30 peut présenter une couche isolante entre l'électrode et le silicium, telle que mentionnée en relation avec la figure 2.

Dans les variantes présentées ci-dessus, la plaquette 10 entre les deux électrodes 22 et 30 peut présenter une jonction pn ou non. Des exemples de mise en œuvre du procédé avec ou sans jonction pn sont donnés ci-dessous.

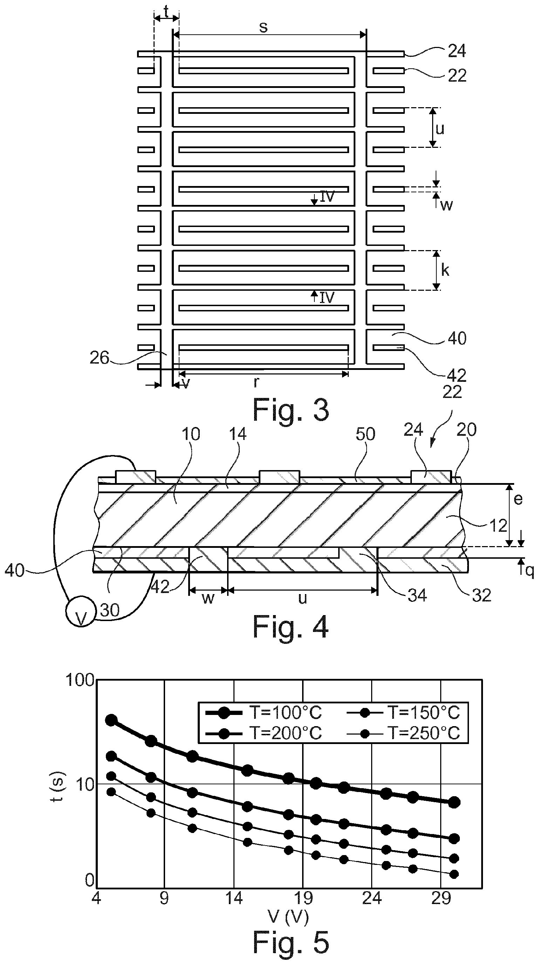

La figure 3 et 4 illustre une configuration possible pour les première et deuxième électrodes. Cette configuration est décrite en détail en relation avec l'exemple 1. L'invention n'est cependant pas limitée à cette configuration.

**Exemple 1**

Un premier exemple de procédé est décrit ci-dessous en relation avec les figures 3 à 5.

Dans cet exemple, une plaquette de silicium cristallin 10 de dimensions 156 mm par 156 mm, de type p dopée au bore avec une concentration de bore sensiblement égale à $8,0 \times 10^{15}$ cm$^{-3}$ et contenant du cuivre à une teneur voisine de $10^{14}$ cm$^{-3}$ est utilisée. Cette plaquette a subi une étape de texturation et de nettoyage. Elle présente une épaisseur e sensiblement égale à 170 μm.

Le procédé suivant les étapes suivantes lui est appliquée :

1) diffusion thermique du phosphore,
2) décapage de la zone diffusée en face arrière 30 et polissage de la face arrière 30, la plaquette 10 présente alors une base p 12 et une couche émetteur, dopéen, 14 sur sa face avant 20,
3) dépôt en face avant 20 d'une couche anti-reflet 50 SiNx:H,
4) dépôt en face arrière 30 d'un empilement multicouche diélectrique 40 de AlOx/SiNx:H,
5) ablation locale au laser d'un empilement multicouche diélectrique 40 pour former des zones découvertes 42,
6) impression d'une première électrode métallique 22 en face avant sous la forme d'une grille et d'une deuxième électrode en aluminium 32 en face arrière 30 sous la forme d'une couche recouvrant ladite face 30 en particulier sur les zones découvertes 42,
7) cuisson autour de 780 °C pour l'activation des électrodes et la prise de contact entre les électrodes 22 et 32 et la plaquette 10, au travers de la couche anti-reflet 50 pour l'électrode 22, et
8) chauffage et application d'une différence de potentiel électrique V entre les deux électrodes 22 et 32 pendant un temps t.

La concentration en cuivre après l'étape de diffusion phosphore est de l'ordre de $10^{11}$ cm$^{-3}$.

La face arrière 30 est recouverte à l'étape 4) d'une couche diélectrique 40 visible sur la figure 4. La couche diélectrique 40 est localement retirée par ablation au laser à l'étape 5) dans des zones découvertes 42. Comme cela est illustré sur les figures 3 et 4, les zones découvertes 42 forment un motif constitué de lignes discontinues parallèles. La largeur $w$ de ces zones 42 est voisine de 50 μm, la distance $u$ entre deux zones 42 parallèles est sensiblement égale à 1,4 mm dans le cas illustré à la figure 3, et la distance r entre deux zones 42 discontinues consécutives d'une ligne du motif, qui dépend du nombre de lignes de jonctions imprimés sur la face avant de la cellule, est comprise entre 10 mm et 150 mm. La distance $t$ entre deux zones 42 discontinues consécutives d'une ligne du motif est comprise entre 200 μm et 10 mm. Le multicouche diélectrique 40 présente une épaisseur *q* comprise entre 10 nm et 500 nm. A l'étape 6), l'ensemble face arrière 30 -multicouche diélectrique 40 est recouverte d'une couche d'aluminium formant la deuxième électrode 32. La couche d'aluminium 32 comble les zones 42 en formant des reliefs venant directement en contact avec la plaquette 10. Ces reliefs forment les pistes 34.

La première électrode 22 en face avant 20 formé à l'étape 6) est constituée d'une pluralité de lignes fines parallèles constituant les pistes 24 reliées entre elles par des lignes de jonction parallèles 26. Les lignes de jonction 26 sont perpendiculaires aux pistes 24 de sorte à former une grille. Les lignes de jonction 26 s'étendent entre deux zones 42 discontinues consécutives d'une ligne du motif à égale distance de ces derniers et les pistes 24 s'étendent entre deux zones 42 parallèles à égale distance de ces dernières. De la sorte, les pistes 24 et lignes de jonction 26 ne se superposent pas aux pistes 34. La première électrode 22 présente de préférence entre 2 et 7 lignes de jonction 26 et entre 60 et 180 pistes 24. De préférence, la largeur *v* des lignes de jonction 26 est comprise entre 0,2 mm et 3 mm. La distance *s* entre deux lignes de jonction 26 est comprise entre 10 mm et 150 mm.

Dans cet exemple, la largeur des pistes est sensiblement égale à la largeur w des zones 42.

Dans cet exemple, les deux électrodes 24 et 34 sont de part et d'autre de la jonction pn.

Un tel exemple de procédé est simple à mettre en œuvre et permet d'avoir champ électrique qui s'applique de façon sensiblement uniforme sur la plaquette 10, ce qui améliore l'extraction des impuretés métalliques de l'ensemble du volume de la plaquette.

Dans l'exemple illustré sur la figure 3, la distance *k* entre deux pistes 24 est sensiblement égale à 1,4 mm et la distance *L* entre une piste 24 et une piste 34 adjacente est sensiblement égale à 0,72 mm.

A partir des équations précédemment présentées, en considérant que $L=L_{Drift}$ et à partir du calcul du coefficient de diffusion du cuivre en prenant en compte les effets conjugués de la présence de bore et de la température, la variation du temps t nécessaire aux atomes de cuivre pour migrer sur une distance de 0,72 mm en fonction de la différence de potentiel électrique V appliquée entre les deux électrodes 22 et 32, a été déterminée, et ce pour différentes température T. La Figure 5 présente les résultats obtenus.

Ainsi, en fonction des cadences de production visées, des capacités de résistance de la cellule à l'augmentation de température et de la différence de potentiel électrique appliquée, les conditions de traitement les plus optimales peuvent être déterminées.

L'étape 8) pourrait consister à appliquer une différence de potentiel électrique de 8 V, à 250°C et ce pendant 5 s.

**Exemple 2**

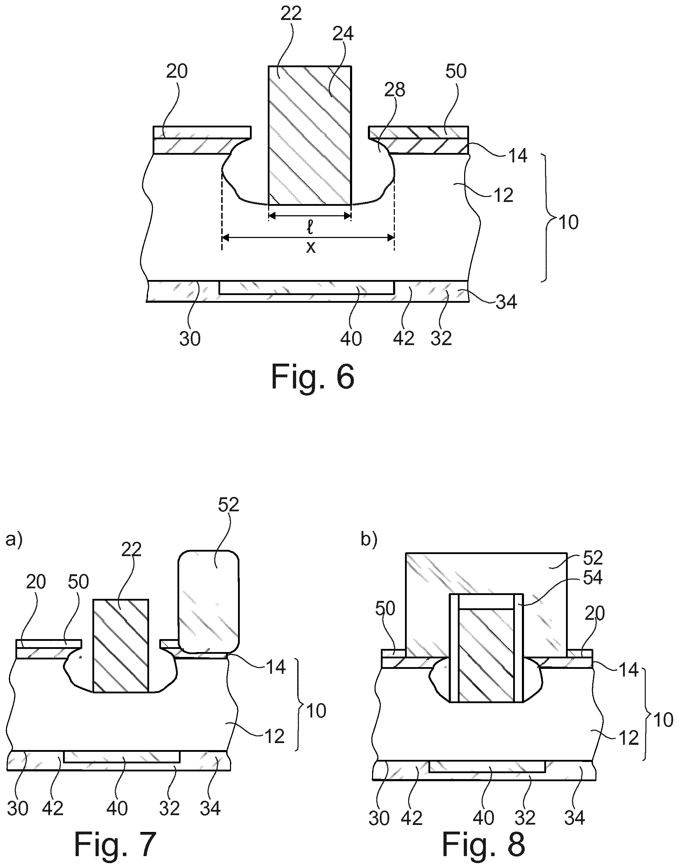

Un deuxième exemple de procédé est décrit ci-dessous en relation avec les figures 6 à 8.

Dans cet exemple, une plaquette de silicium cristallin 10 de dimensions 156 mm par 156 mm de type p dopée au bore avec une concentration de bore sensiblement égale à $8,0\times10^{15}$ cm$^{-3}$ et contenant du cuivre à une teneur voisine de $10^{14}$ cm$^{-3}$ est utilisée. Cette plaquette a subi une étape de texturation et de nettoyage. Elle présente une épaisseur e sensiblement égale à 170 μm.

Le procédé suivant les étapes suivantes lui est appliqué :

1) diffusion thermique du phosphore,
2) décapage de la zone diffusée en face arrière 30 et polissage de la face arrière 30, la plaquette 10 présente alors une base p 12 et une couche émetteur, dopée n, 14 sur sa face avant 20,
3) dépôt en face avant 20 d'une couche anti-reflet 50 SiNx:H,
4) dépôt en face arrière 30 d'une couche diélectrique 40 de AlOx/SiNx:H,
5) ablation locale au laser de la couche antireflet 50 en face avant 20 pour former des zones sans diélectrique,
6) attaque au KOH concentré de la face avant 20 pour former dans la plaquette, au niveau des zones sans diélectrique formées à l'étape 5, des creux 28 traversant la couche émetteur 14,
7) ablation locale au laser de la couche diélectrique 40 pour former des zones découvertes 42,
8) impression d'une deuxième électrode en aluminium 32 en face arrière 30 sous la forme d'une couche recouvrant ladite face 30 sur au moins les zones découvertes 42,
9) dépôt sur la face avant 20, dans les creux 28, d'une première électrode métallique 22, par exemple en argent, cuivre, nickel, aluminium ou en un alliage inter-métallique,
10) cuisson autour de 780°C pour l'activation des électrodes et la prise de contact entre les électrodes 22 et 32 et la plaquette 10,
11) chauffage et application d'une différence de potentiel électrique V entre les deux électrodes 22 et 32 pendant un temps t,
12) dépôt sur la face avant 20 d'une troisième électrode métallique 52 hors des creux 28, l'électrode 52 étant espacée de l'électrode 22, et
13) cuisson autour de 780°C pour l'activation de l'électrode 52 et la prise de contact entre l'électrode 52 et la plaquette 10 au travers de la couche anti-reflet 50.

Les électrodes 22 et 32 se présentes et sont agencées de la même manière que dans l'exemple 1.

L'électrode 22 est disposée dans les creux 28 de sorte que les électrodes 22 et 32 sont disposées de part et d'autre de la base p 12. La plaquette 10 entre les deux électrodes 22 et 32 ne présente donc pas de jonction pn.

Dans cet exemple, les creux 28 présentent une largeur maximale $x$ comprise entre 600 nm et 70 $\mu$m. La largeur $l$ des pistes 24 et 34 est comprise entre 500 nm et 50 $\mu$m.

Dans l'exemple 2, les électrodes 22 et 52 ne sont pas en contact et sont donc isolées électriquement. Il est important que ces deux électrodes soient isolées pour éviter que lors de l'utilisation de l'une des électrodes 22 et 52, l'autre des électrodes 22 ou 52 ne parasite la première.

L'étape 11) pourrait consister à appliquer une différence de potentiel électrique de 8 V, à 250°C et ce pendant 5 s.

En variante illustrée à la figure 8, l'étape 12) peut être remplacée par les deux étapes suivantes :

12') dépôt d'une couche isolante 54 sur l'électrode 22,
12") dépôt d'une troisième électrode 52 en face avant 20.

Dans cette variante, l'électrode 22 est isolée électriquement de l'électrode 52 par une couche isolante 54. L'électrode 52 doit être partiellement en contact avec la couche émetteur 14.

## Exemple 3

Un troisième exemple de réalisation est décrit ci-dessous.

Dans cet exemple, une plaquette de silicium cristallin 10 de dimensions 156 mm par 156 mm$^2$ de type p dopée au bore avec une concentration de bore sensiblement égale à $8,0 \times 10^{15}$ cm$^{-3}$ et contenant du cuivre à une teneur voisine de $10^{14}$ cm$^{-3}$ est utilisée. Cette plaquette a subi une étape de texturation et de nettoyage. Elle présente une épaisseur e sensiblement égale à 170 $\mu$m. La plaquette 10 présente une base p 12 et une couche émetteur, dopée n$^+$, 14 sur sa face avant 20.

Le procédé suivant les étapes suivantes lui est appliqué :

1) dépôt d'une couche diélectrique contenant du phosphore sur la face avant 20,
2) dépôt d'une couche diélectrique contenant du bore sur la face arrière 30,
3) recuit pour la co-diffusion dans la plaquette du bore et du phosphore, la plaquette 10 présente alors une base p 12, une couche émetteur 14, dopée n sur sa face avant 20 et une couche émetteur 16 dopée p dite également couche collecteur des trous dopée p, sur sa face arrière 30,
4) dépôt en face arrière 30 d'une couche anti-reflet 50 SiNx:H,

5) impression par sérigraphie d'une première électrode 22 en argent en face avant 20 sous la forme d'un peigne et d'une deuxième électrode 32 en argent et aluminium sur la face de la couche anti reflet 50, soit la face arrière 30, sous la forme d'un peigne dont les pistes 34 sont imbriquées entre les pistes 24 de la première électrode 22,
6) cuisson à une température comprise entre 400°C et 600°C pour améliorer la conductivité des électrodes,
7) chauffage et application d'une différence de potentiel électrique V entre les deux électrodes 22 et 32 pendant un temps t,
8) cuisson autour de 850°C pour la prise de contact entre les électrodes 22 et 32 et la plaquette 10 au travers de la couche anti-reflet 50.

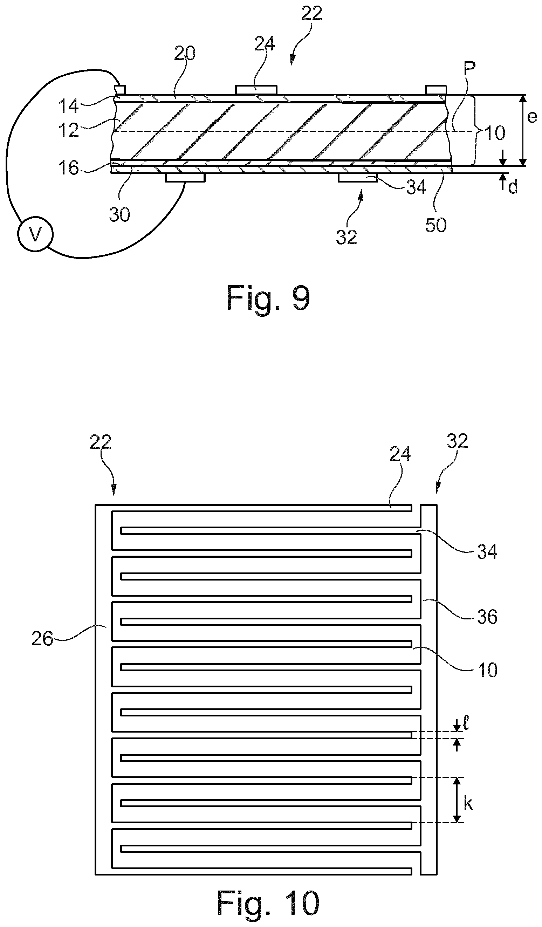

Dans cet exemple, les électrodes 22 et 32 sont imprimées par sérigraphie à l'étape 5) de part et d'autre de la plaquette selon la configuration illustrée sur la figure 10. L'électrode 22 se présente sous la forme d'une pluralité de pistes 24 reliées entre elles à une de leur extrémité par une ligne de jonction 26 perpendiculaire aux pistes 24. Les pistes 24 sont identiques et parallèles entre elles. L'électrode 32 se présente sous la forme d'une pluralité de pistes 34 s'intercalant en vue du dessus, entre les pistes 24 à égale distance de ces dernières. Les pistes 34 ne se superposent ni aux pistes 24 ni à la ligne de jonction 26. Les lignes 34 sont reliées entre elles à leur extrémité opposée à la ligne de jonction 26 par une ligne de jonction 36 perpendiculaire aux pistes 34. Dans cette configuration, les électrodes 22 et 32 sont, en vue du dessus, interdigitées et ne se superposent pas.

Dans cette configuration, la différence de potentiel électrique appliquée à l'étape 7) est préférentiellement comprise, en valeur absolue, entre 10 V et 10 kV. L'étape 7) peut consister à appliquer une différence de potentiel électrique de 800 V, à 250°C et ce pendant 5 s.

## Exemple 4

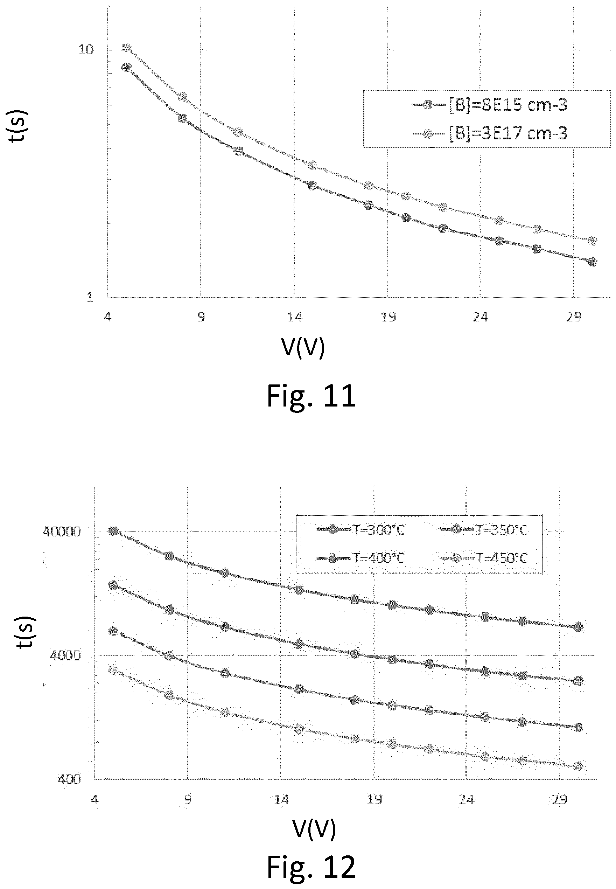

Un quatrième exemple de procédé est décrit ci-dessous en relation avec la figure 11.

Dans cet exemple, deux plaquettes de silicium cristallin 10 sensiblement identique à celle de l'exemple 1 à la teneur en bore près ont subies le procédé de l'exemple 1, la température de chauffage de l'étape 10 étant réalisée à 250°C. Les plaquettes de silicium cristallin présentent respectivement une teneur en bore de $3 \times 10^{17}$ cm$^{-3}$ et de $8 \times 10^{15}$ cm$^{-3}$.

La variation du temps $t$ nécessaire aux atomes de cuivre pour migrer sur une distance de 1 mm en fonction de la différence de potentiel électrique V appliquée entre les deux électrodes 22 et 32, a été déterminée, et ce pour chacune des plaquettes de silicium cristallin. La figure 11 présente les résultats obtenus.

Comme visible sur la figure 11, pour une concentration en bore de $3 \times 10^{17}$ cm$^{-3}$, il est judicieux sous une différence de potentiel de 8 V, à 250°C, d'avoir un traitement d'une durée de 7 s et pour une concentration en bore de $3 \times 10^{15}$ cm$^{-3}$, il est judicieux sous une différence de potentiel de 8 V, à 250°C, d'avoir un traitement d'une durée de 5 s environ. A noter que pour des teneurs en bore inférieures à $8,0 \times 10^{15}$ cm$^{-3}$ les temps de traitement sont identiques à ceux correspondants aux substrats dopés à $8,0 \times 10^{15}$ cm$^{-3}$. L'invention peut être mise en œuvre pour des teneurs en bore dans la plaquette de silicium plus faible que celles des exemples 1 et 4, par exemple de l'ordre de $10^{13}$ à $10^{14}$ cm$^{-3}$.

Ainsi, la teneur en bore a une influence sur le coefficient de diffusion du cuivre pour des teneurs en bore supérieure ou égale à $10^{16}$ cm$^{-3}$ et l'invention n'est pas limitée à une teneur en bore particulière dans la plaquette de silicium.

## Exemple 5

Un cinquième exemple de procédé est décrit ci-dessous en relation avec la figure 12.

On considère une plaquette de silicium cristallin 10 de dimensions 156 mm par 156 mm de type p dopée au bore avec une concentration de bore sensiblement égale à $8,0 \times 10^{15}$ cm$^{-3}$ et contenant du fer à une teneur voisine de $10^{14}$ cm$^{-3}$ est utilisée. Cette plaquette a subi une étape de texturation et de nettoyage. Elle présente une épaisseur $e$ sensiblement égale à 170 $\mu$m.

Le procédé de l'exemple 1 lui est appliqué.

La concentration en fer après l'étape de diffusion phosphore est de l'ordre de $2 \times 10^{13}$ cm$^{-3}$.

A partir des équations précédemment présentées, en considérant que $L = L_{Drift}$ et à partir du calcul du coefficient de diffusion du fer en prenant en compte les effets conjugués de la présence de bore et de la température, la variation du temps $t$ nécessaire aux atomes de fer pour migrer sur une distance de 1 mm en fonction de la différence de potentiel électrique V appliquée entre les deux électrodes 22 et 32, a été déterminée, et ce pour différentes température $T$. La figure 12 présente les résultats obtenus.

Ainsi, en fonction des cadences de production visées, des capacités de résistance de la cellule à l'augmentation de température et de la différence de potentiel électrique appliquée, les conditions de traitement les plus optimales peuvent être déterminées.

L'étape 10) pourrait consister à appliquer une différence de potentiel électrique de 20 V, à 450°C et ce pendant 800 s.

Bien entendu, l'invention n'est pas limitée aux exemples qui viennent d'être décrits.

Les électrodes peuvent présenter des formes différentes que celles décrites, par exemple ondulé, curviligne ou concentrique.

Les électrodes peuvent être déposées autrement que par sérigraphie, notamment par pulvérisation, électro-dépôt, évaporation sous vide.

## Revendications

1. Procédé d'extraction d'impuretés métalliques d'une plaquette de silicium cristallin (10) comportant au moins une étape d'application, pendant une durée supérieure ou égale à 1 seconde, et de préférence pendant une durée entre 1 seconde et 200 secondes , une différence de potentiel électrique entre une première électrode (22) disposée du côté d'une première face (20) de la plaquette (10) et une deuxième électrode (32) disposée du côté de la deuxième face (30) de la plaquette (10) pour faire migrer les impuretés métalliques vers une des première ou deuxième faces (20, 30) de la plaquette (10), la différence de potentiel électrique étant, en valeur absolue, comprise entre 1V et 10kV, et de préférence comprise entre 3V et 5kV, la première électrode (22) comportant au moins deux pistes (24) et la deuxième électrode (32) comportant au moins une piste (34) dont la projection sur la première face (20) de la plaquette (10) selon une normale à cette dernière est intercalée entre les deux pistes (24) adjacentes de la première électrode (22), de préférence disjointe des pistes (24) de première électrode (22).

2. Procédé selon la revendication 1, la piste (34) de la deuxième électrode (32) étant à égale distance des pistes (24) de première électrode (22).

3. Procédé selon l'une quelconque des revendications précédentes, la première électrode (22) se présentant sous la forme d'un peigne, chaque dent du peigne constituant une piste (24) de première électrode (22), la deuxième électrode (32) présentant une pluralité de pistes (34) dont les projections sur la première face (20) de la plaquette (10) selon une normale à cette dernière sont intercalées entre deux pistes (24) adjacentes de la première électrode (22).

4. Procédé selon l'une quelconque des revendications précédentes, comportant une étape de recouvrement partielle de la deuxième face (30) de la plaquette (10) par au moins une couche diélectrique (40), puis une étape de dépôt de la deuxième électrode (32) pour qu'elle s'étende sur une ou plusieurs zones (42) de la deuxième face de la plaquette dépourvues de couche diélectrique (40) pour définir la ou les pistes (34) de deuxième électrode (32).

5. Procédé selon l'une quelconque des revendications précédentes, comportant une étape d'impression des première et deuxième électrodes (22, 32) par sérigraphie.

6. Procédé selon l'une quelconque des revendications précédentes, le procédé étant mis en œuvre à une température comprise entre 10°C et 850°C, avantageusement entre 15°C et 300°C, et de préférence entre 80°C et 270°C.

7. Procédé selon l'une quelconque des revendications précédentes, comportant une étape de dépôt des pistes (24) de première électrode (22) directement en contact avec la première face (20) de la plaquette (10) ou comportant une étape de recouvrement partielle de la première face (20) de la plaquette (10) d'une couche isolante (26), étant de préférence un empilement de plusieurs couches diélectriques, d'épaisseur $d$ comprise entre 2 nm et 500 nm, mieux entre 10 nm et 300 nm et une étape de dépôt des pistes de première électrode (24) sur la couche isolante (26).

8. Procédé selon l'une quelconque des revendications précédentes, comportant une étape de dépôt de la ou des pistes (34) de deuxième électrode (32) en contact de la deuxième face (30) de la plaquette (10).

9. Procédé selon l'une quelconque des revendications 1 à 8, comportant une étape de recouvrement au moins partielle de la deuxième face (30) de la plaquette (10) d'une couche isolante (36), étant de préférence un empilement de plusieurs couches diélectriques, d'épaisseur d comprise entre 2 nm et 500 nm, mieux entre 10 nm et 300 nm et une étape de dépôt de la ou des pistes (34) de deuxième électrode (32) sur la couche isolante (36), la différence de potentiel électrique appliquée entre les première et deuxième électrodes (22, 32) étant de préférence comprise, en valeur absolue, entre 10 V et 10 kV.

10. Procédé selon les revendications 7 et 9, la différence de potentiel électrique appliquée entre les première et deuxième électrodes (22, 32) étant comprise, en valeur absolue, entre 1 V et 100 V.

11. Procédé selon l'une quelconque des revendications précédentes, la plaquette de silicium (10) ayant une base (12) et au moins une couche émetteur (14) et le procédé comportant une étape de gravure partielle de la première face (20) ou la deuxième face (30) de la plaquette (10) traversant la couche émetteur (14) ; les pistes (24) de la première électrode (22) étant disposées dans les zones gravées (26) de la plaquette, sans contact avec la couche émetteur(14), de préférence le procédé .

12. Procédé selon la revendication 11, comportant une étape de dépôt d'une troisième électrode (52) sur la première face (20) de la plaquette (10) dans les zones non gravées de la plaquette, la troisième électrode (52) étant espacée de la première électrode (22).

13. Procédé selon la revendication 11, comportant des étapes de dépôt d'une couche d'un matériau isolant (54) sur la première électrode (22) et de dépôt d'une troisième électrode (52) sur la première face (20) de la plaquette (10) dans la zone non gravée de la plaquette et au moins partiellement sur la couche de matériau isolant (54).

14. Procédé selon la revendication 11, comportant une étape de retrait de la première électrode (22) après l'étape d'application de la différence de potentiel électrique.

15. Procédé selon l'une quelconque des revendications précédentes, comportant une étape de recuit de la plaquette (10), en particulier à une température comprise entre 600°C et 1300°C pendant une durée comprise entre 1s et 10 min avant un refroidissement à une vitesse de refroidissement supérieure ou égale en valeur absolue à 10 K.s$^{-1}$, l'étape de recuit ayant lieu simultanément à l'étape d'application de la différence de potentiel électrique.

**Patentansprüche**

1. Verfahren zur Extraktion metallischer Verunreinigungen aus einem Wafer aus kristallinem Silizium (10), welches wenigstens einen Schritt des Anlegens, während einer Dauer, die größer oder gleich 1 Sekunde ist, vorzugsweise während einer Dauer zwischen 1 Sekunde und 200 Sekunden, einer elektrischen Potentialdifferenz zwischen einer auf der Seite einer ersten Fläche (20) des Wafers (10) angeordneten ersten Elektrode (22) und einer auf der Seite der zweiten Fläche (30) des Wafers (10) angeordneten zweiten Elektrode (32), um zu bewirken, dass die metallischen Verunreinigungen in Richtung einer von der ersten oder zweiten Fläche (20, 30) des Wafers (10) wandern, wobei die elektrische Potentialdifferenz dem absoluten Betrag nach zwischen 1 V und 10 kV liegt und vorzugsweise zwischen 3 V und 5 kV liegt, wobei die erste Elektrode (22) wenigstens zwei Leiterbahnen (24) aufweist und die zweite Elektrode (32) wenigstens eine Leiterbahn (34) aufweist, deren Projektion auf die erste Fläche (20) des Wafers (10) entlang einer Normalen zu diesem Letzteren zwischen den zwei benachbarten Leiterbahnen (24) der ersten Elektrode (22) angeordnet ist und vorzugsweise zu den Leiterbahnen (24) der ersten Elektrode (22) disjunkt ist.

2. Verfahren nach Anspruch 1, wobei sich die Leiterbahn (34) der zweiten Elektrode (32) in gleichem Abstand zu den Leiterbahnen (24) der ersten Elektrode (22) befindet.

3. Verfahren nach einem der vorhergehenden Ansprüche, wobei die erste Elektrode (22) die Form eines Kamms aufweist, wobei jede Zinke des Kamms eine Leiterbahn (24) der ersten Elektrode (22) bildet, wobei die zweite Elektrode (32) mehrere Leiterbahnen (34) aufweist, deren Projektionen auf die erste Fläche (20) des Wafers (10) entlang einer Normalen zu diesem Letzteren zwischen zwei benachbarten Leiterbahnen (24) der ersten Elektrode (22) angeordnet sind.

4. Verfahren nach einem der vorhergehenden Ansprüche, welches einen Schritt des teilweisen Bedeckens der zweiten Fläche (30) des Wafers (10) durch wenigstens eine dielektrische Schicht (40) umfasst, und anschließend einen Schritt der Aufbringung der zweiten Elektrode (32), so dass sie sich auf einem oder mehreren Bereichen (42) der zweiten Fläche des Wafers erstreckt, die nicht mit einer dielektrischen Schicht (40) versehen sind, um die Leiterbahn oder die Leiterbahnen (34) der zweiten Elektrode (32) zu definieren.

5. Verfahren nach einem der vorhergehenden Ansprüche, welches einen Schritt des Druckens der ersten und zweiten Elektrode (22, 32) durch Siebdruck umfasst.

6. Verfahren nach einem der vorhergehenden Ansprüche, wobei das Verfahren bei einer Temperatur zwischen 10 °C und 850 °C, vorteilhafterweise zwischen 15 °C und 300 °C und vorzugsweise zwischen 80 °C und 270 °C durchgeführt wird.

7. Verfahren nach einem der vorhergehenden Ansprüche, welches einen Schritt der Aufbringung der Leiterbahnen (24) der ersten Elektrode (22) direkt in Kontakt mit der ersten Fläche (20) des Wafers (10) umfasst oder einen Schritt des teilweisen Bedeckens der ersten Fläche (20) des Wafers (10) mit einer isolierenden Schicht (26), die vorzugsweise ein Stapel von mehreren dielektrischen Schichten ist, mit einer Dicke d zwischen 2 nm und 500 nm, besser zwischen 10 nm und 300 nm, und einen Schritt der Aufbringung der Leiterbahnen der ersten Elektrode (24) auf die isolierende Schicht (26) umfasst.

8. Verfahren nach einem der vorhergehenden Ansprüche, welches einen Schritt der Aufbringung der Leiterbahn oder der Leiterbahnen (34) der zweiten Elektrode (32) in Kontakt mit der zweiten Fläche (30) des Wafers (10) umfasst.

9. Verfahren nach einem der Ansprüche 1 bis 8, welches einen Schritt des wenigstens teilweisen Bedeckens der zweiten Fläche (30) des Wafers (10) mit einer isolierenden Schicht (36), die vorzugsweise ein Stapel von mehreren dielektrischen Schichten ist, mit einer Dicke d zwischen 2 nm und 500 nm, besser zwischen 10 nm und 300 nm, und einen Schritt der Aufbringung der Leiterbahn oder der Leiterbahnen (34) der zweiten Elektrode (32) auf die isolierende Schicht (36) umfasst, wobei die elektrische Potentialdifferenz, die zwischen der ersten und der zweiten Elektrode (22, 32) angelegt wird, vorzugsweise dem absoluten Betrag nach zwischen 10 V und 10 kV liegt.

10. Verfahren nach den Ansprüchen 7 und 9, wobei die elektrische Potentialdifferenz, die zwischen der ersten und der zweiten Elektrode (22, 32) angelegt wird, dem absoluten Betrag nach zwischen 1 V und 100 V liegt.

11. Verfahren nach einem der vorhergehenden Ansprüche, wobei der Siliziumwafer (10) eine Basis (12) und wenigstens eine Emitterschicht (14) aufweist und das Verfahren einen Schritt der teilweisen Ätzung der ersten Fläche (20) oder der zweiten Fläche (30) des Wafers (10), welche die Emitterschicht (14) durchquert, umfasst; wobei die Leiterbahnen (24) der ersten Elektrode (22) in den geätzten Bereichen (26) des Wafers angeordnet sind, ohne Kontakt mit der Emitterschicht (14), vorzugsweise das Verfahren.

12. Verfahren nach Anspruch 11, welches einen Schritt der Aufbringung einer dritten Elektrode (52) auf die erste Fläche (20) des Wafers (10) in den nicht geätzten Bereichen des Wafers umfasst, wobei die dritte Elektrode (52) von der ersten Elektrode (22) beabstandet ist.

13. Verfahren nach Anspruch 11, welches Schritte der Aufbringung einer Schicht aus einem isolierenden Material (54) auf die erste Elektrode (22) und der Aufbringung einer dritten Elektrode (52) auf die erste Fläche (20) des Wafers (10) in dem nicht geätzten Bereich des Wafers und wenigstens teilweise auf der Schicht aus isolierendem Material (54) umfasst.

14. Verfahren nach Anspruch 11, welches einen Schritt des Zurückziehens der ersten Elektrode (22) nach dem Schritt des Anlegens der elektrischen Potentialdifferenz umfasst.

15. Verfahren nach einem der vorhergehenden Ansprüche, welches einen Schritt des Temperns des Wafers (10) umfasst, insbesondere bei einer Temperatur zwischen 600 °C und 1300 °C während einer Dauer zwischen 1 s und 10 min vor einer Abkühlung mit einer Abkühlgeschwindigkeit, die dem absoluten Betrag nach größer oder gleich 10 K.s$^{-1}$ ist, wobei der Schritt des Temperns gleichzeitig mit dem Schritt des Anlegens der elektrischen Potentialdifferenz stattfindet.

## Claims

1. Process for the extraction of metal impurities from a crystalline silicon wafer (10) comprising at least one stage of application, for a period of time of greater than or equal to 1 second and preferably for a period of time between 1 second and 200 seconds, an electric potential difference between a first electrode (22) positioned on the side of a first face (20) of the wafer (10) and a second electrode (32) positioned on the side of the second face (30) of the wafer (10) in order to cause the metal impurities to migrate towards one of the first or second faces (20, 30) of the wafer (10), the electric potential difference being, in absolute value, between 1 V and 10 kV and preferably between 3 V and 5 kV, the first electrode (22) comprising at least two tracks (24) and the second electrode (32) comprising at least one track (34), the projection of which onto the first face (20) of the wafer (10) along a normal to the latter is inserted between the two adjacent tracks (24) of the first electrode (22), preferably separated from the tracks (24) of the first electrode (22).

2. Process according to Claim 1, the track (34) of the second electrode (32) being at an equal distance from the tracks (24) of first electrode (22).

3. Process according to either one of the preceding claims, the first electrode (22) being provided in the form of a comb, each tooth of the comb constituting a track (24) of the first electrode (22), the second electrode (32) exhibiting a plurality of tracks (34), the projections of which onto the first face (20) of the wafer (10) along a normal to the latter are inserted between two adjacent tracks (24) of the first electrode (22).

4. Process according to any one of the preceding claims, comprising a stage of partial covering of the second face (30) of the wafer (10) by at least one dielectric layer (40), then a stage of deposition of the second electrode (32) in order for it to extend over one or more zones (42) of the second face of the wafer which is/are devoid of dielectric layer (40), in order to define the track(s) (34) of the second electrode (32).

5. Process according to any one of the preceding claims, comprising a stage of printing of the first and second electrodes (22, 32) by silkscreen printing.

6. Process according to any one of the preceding claims, the process being carried out at a temperature of between 10°C and 850°C, advantageously between 15°C and 300°C and preferably between 80°C and 270°C.

7. Process according to any one of the preceding claims, comprising a stage of deposition of the tracks (24) of first electrode (22) directly in contact with the first face (20) of the wafer (10) or comprising a stage of partial covering of the first face (20) of the wafer (10) with an insulating layer (26), preferably being a stack of several dielectric layers, with a thickness d of between 2 nm and 500 nm, better still between 10 nm and 300 nm, and a state of deposition of the tracks of first electrode (24) on the insulating layer (26).

8. Process according to any one of the preceding claims, comprising a stage of deposition of the track(s) (34) of second electrode (32) in contact with the second face (30) of the wafer (10).

9. Process according to any one of Claims 1 to 8, comprising a stage of at least partial covering of the second face (30) of the wafer (10) with an insulating layer (36), preferably being a stack of several dielectric layers, with a thickness d of between 2 nm and 500 nm, better still between 10 nm and 300 nm, and a stage of deposition of the track(s) (34) of second electrode (32) on the insulating layer (36), the difference in electric potential applied between the first and second electrodes (22, 32) preferably being of, in absolute value, between 10 V and 10 kV.

10. Process according to Claims 7 and 9, the applied electric potential difference between the first and second electrodes (22, 32) being of, in absolute value, between 1 V and 100 V.

11. Process according to any one of the preceding claims, the silicon wafer (10) having a base (12) and at least one emitter layer (14) and the process comprising a stage of partial etching of the first face (20) or the second face (30) of the wafer (10) passing through the emitter layer (14); the tracks (24) of the first electrode (22) being positioned in the etched zones (26) of the wafer, without contact with the emitter layer (14), preferably the process.

12. Process according to Claim 11, comprising a stage of deposition of a third electrode (32) on the first face (20) of the wafer (10) in the unetched zones of the wafer, the third electrode (32) being spaced out from the first electrode (22).

13. Process according to Claim 11, comprising stages of deposition of a layer of an insulating material (54) on the first electrode (22) and of deposition of a third electrode (52) on the first face (20) of the wafer (10) in the unetched zone of the wafer and at least partially on the layer of insulating material (54).

14. Process according to Claim 11, comprising a stage of withdrawal of the first electrode (22) after the stage of application of the electric potential difference.

15. Process according to any one of the preceding claims, comprising a stage of annealing of the wafer (10), in particular at a temperature of between 600°C and 1300°C, for a period of time of between 1 s and 10 min, before cooling at a cooling rate of greater than or equal, in absolute value, to 10 k.s$^{-1}$, the annealing stage taking place simultaneously with the stage of application of the electric potential difference.

Fig. 1

Fig. 2

Fig. 3

Fig. 4

Fig. 5

Fig. 6

Fig. 7

Fig. 8

Fig. 9

Fig. 10

Fig. 11

Fig. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2007095774 B
- WO 2013045767 A
- US 5770000 A
- US 6534748 B
- WO 2007107351 A
- DE 102009059300
- FR 2949607

**Littérature non-brevet citée dans la description**

- **W.P. LEE et al.** *Journal of ELECTRONIC MATERIALS,* 2005, vol. 34 (7
- **S. DUBOIS et al.** *SolMat,* 2016